Europäisches Patentamt

European Patent Office

Office européen des brevets

(11) Veröffentlichungsnummer: **0 239 725**
**A2**

(12) **EUROPÄISCHE PATENTANMELDUNG**

(21) Anmeldenummer: **87100643.3**

(22) Anmeldetag: **19.01.87**

(51) Int. Cl.⁴: **H01B 7/32**

(30) Priorität: **28.02.86 DE 3606687**

(43) Veröffentlichungstag der Anmeldung:
**07.10.87 Patentblatt 87/41**

(84) Benannte Vertragsstaaten:
**AT BE CH DE ES FR GB GR IT LI LU NL SE**

(71) Anmelder: **W.L. Gore & Co. GmbH**
**Wernher-von-Braun-Strasse 18**
**D-8011 Putzbrunn(DE)**

(72) Erfinder: **Pröckl, Peter**
**Rehenbühl 43**
**D-8821 Pfofeld(DE)**

(74) Vertreter: **Klunker . Schmitt-Nilson . Hirsch**
**Winzererstrasse 106**
**D-8000 München 40(DE)**

(54) **Kabelschutzvorrichtung und elektrisches Kabel hierfür.**

㉗ Kabelschutzvorrichtung zur Überwachung eines elektrischen Kabels auf Unversehrtheit. Nutzleiter (1) des elektrischen Kabels sind in konzentrischer Weise von drei Schirmleitern (7, 10, 12) umgeben, die sowohl von den Nutzleitern (1) als auch voneinander elektrisch isoliert sind. Zu den drei Schirmleitern gehören ein Sendeschirm (7), ein Empfangsschirm (12) und eine dazwischen befindliche Strahlungsabschirmung (10). An den Sendeschirm (7) ist ein Überwachungssender (14) angeschlossen. Der Empfangsschirm (12) ist mit einem Überwachungsempfänger (15) verbunden. Die Strahlungsabschirmung (10) schirmt in unversehrtem Zustand den Empfangsschirm (12) vor Hochfrequenzenergie ab, die vom Sendeschirm (7) abgestrahlt wird. Wird die Strahlungsabschirmung (10) geöffnet, um an die Nutzleiter (1) des Kabels heranzukommen, gelangt vom Sendeschirm (7) abgestrahlte Hochfrequenzenergie auf den Empfangsschirm (12), was von einer Auswerteeinrichtung festgestellt wird.

Die Erfindung betrifft eine Kabelschutzvorrichtung gemäß Oberbegriff des Anspruches 1 und ein dafür geeignetes Kabel gemäß Oberbegriff des Anspruches 10.

Es ist häufig erwünscht, elektrische Kabel auf Unversehrtheit zu überwachen. Eine solche Überwachung führt man beispielsweise für Kabel zum Anschließen elektrischer Geräte, beispielsweise Rasenmäher, durch, um einen Schutz vor Unfällen zu erreichen, die infolge einer Beschädigung eines spannungsführenden Kabels auftreten können. Auch bei Nachrichtenübertragungskabeln kann eine Überwachung auf Unversehrtheit sinnvoll sein, um eine unbefugte Datenanzapfung zu verhindern.

Aus der DE-OS 33 38 332 ist ein elektrisches Kabel zur Stromversorgung elektrischer Geräte bekannt, das einen Endes mit einem Verbindungsstecker und anderen Endes mit einer Verbindungsbuchse versehen ist. Zusätzlich zu den der Netzspannungsübertragung dienenden Nutzleitern weist dieses Kabel Überwachungsleiter auf, die in die Kabelisolierung eingebettet sind. Die Überwachungsleiter dienen der galvanischen Verbindung eines in der Verbindungsbuchse untergebrachten Überwachungssenders und eines im Verbindungsstecker untergebrachten Überwachungsempfängers. An den Überwachungsempfänger ist eine Schutzschaltung angeschlossen. Sobald eine Beschädigung der Überwachungsleiter festgestellt wird, wird die Schutzschaltung aktiv und schaltet das Kabel in einen spannungsfreien Zustand.

Aus der US-PS 2 691 698 ist eine Schutzvorrichtung für ein Telefonkabel bekannt, bei dem auf einen die Telefon leitungsdrähte umgebenden Isoliermantel zwei Überwachungsleiter in gegenläufiger Wendelform gewickelt sind. An dem einen Kabelende sind die beiden Überwachungsleiter mit Hilfe einer RC-Schaltung miteinander verbunden. Am anderen Kabelende sind die beiden Überwachungsleiter über eine Reihenschaltung aus einem im Ruhezustand offenen Relais, einem im Ruhezustand geschlossenen Relais und einer Batterie miteinander verbunden. Wird bei dem Versuch, zu den Telefonleitungsdrähten vorzudringen, zwischen den beiden Überwachungsleitern ein Kurzschluß oder eine Unterbrechung verursacht, wird über das eine oder das andere der beiden Relais eine Alarmeinrichtung eingeschaltet. Zusätzlich werden die Überwachungsleiter mit dem Ausgangssignal eines Störtongenerators beaufschlagt. Dies führt zum Aufbau eines Störmagnetfeldes um die äußere Überwachungsleiterwendel. Dieses Störmagnetfeld soll das ohne eine Kabelbeschädigung durchführbare induktive Anzapfen des Telefonkabels mittels einer um das Kabel herumgelegten Induktionsspule behindern.

Der mit diesen bekannten Methoden erreichbare Schutz ist jedoch dann nicht ausreichend, wenn es um die Übertragung hochgradig - schutzbedürftiger Daten geht. So muß man beispielsweise sicher verhindern, daß Datenübertragungskabel angezapft werden, über welche Bankcomputer miteinander oder mit Peripheriegeräten wie beispielsweise Geldausgabeautomaten verbunden werden. Die bekannten Kabelschutzvorrichtungen sind zu leicht überwindbar, um derartige Datenübertragungskabel genügend zu sichern. Bei den bekannten Schutzvorrichtungen braucht man lediglich die Überwachungsleiter elektrisch zu überbrücken, bevor man sie durchtrennt, um ohne Alarmauslösung an die zu - schützende Nutzleiter herankommen zu können.

Der Erfindung liegt die Aufgabe zugrunde, eine Kabelschutzvorrichtung zu schaffen, die zu einer wesentlich höheren Sicherheit gegen unbefugtes Anzapfen führt, und ein dafür geeignetes Kabel verfügbar zu machen.

Eine Kabelschutzvorrichtung zur Lösung dieser Aufgabe ist im Anspruch 1 angegeben und kann gemäß den Ansprüchen 2 bis 7 vorteilhaft weitergebildet werden. Zur Lösung dieser Aufgabe geeignete Kabel sind den Ansprüchen 10 und 11 angegeben und können gemäß den Ansprüchen 12 bis 17 vorteilhaft weitergebildet werden.

Die erfindungsgemäße Methode besteht also darin, die gegen unbefugten Eingriff zu - schützenden Nutzleiter in eine Funkstrecke einzuschließen, die eine Sendeantenne in Form des Sendeschirms, eine Empfangsantenne in Form des Empfangsschirms und dazwischen eine Hochfrequenzdichtung in Form der Strahlungsabschirmung aufweist, mittels welcher die Funkstrecke unterbrochen wird, solange die Strahlungsabschirmung unversehrt ist. Kommt es bei dem Versuch, durch Öffnen der Schirmleiter an die Nutzleiter heranzukommen, zu einer Beschädigung der Strahlungsabschirmung, bekommt die Hochfrequenzdichtung zwischen Sendeantenne und Empfangsantenne ein Leck und kann die Empfangsantenne von Strahlungsenergie erreicht werden. Wird der Empfang von Hochfrequenzenergie durch die Empfangsantenne von der Auswerteeinrichtung detektiert, kann Alarm ausgelöst werden.

Da bei der erfindungsgemäßen Methode durch das Öffnen der Strahlungsabschirmung eine Funkstrecke geöffnet wird, läßt sich die Alarmauslösung nicht dadurch verhindern, daß man einen oder mehrere der drei Schirmleiter vor dem Öffnen elektrisch überbrückt. Jegliche Beschädigung der Strahlungsabschirmung führt somit unweigerlich zur Alarmgabe.

Mit der erfindungsgemäßen Methode kann man je nach Wunsch entweder sämtliche Nutzleiter des Kabels schützen, indem man mit den Schirmleitern sämtliche Nutzleiter umschließt, oder nur eine Teilanzahl der Nutzleiter, indem man nur diese in die erfindungsgemäßen Schirmleiter einschließt, die dann im Gesamtkabel mit untergebracht werden.

Wenn hier im Zusammenhang mit den erfindungsgemäßen Schirmleitern der Begriff "konzentrisch" verwendet wird, so soll dies nicht solche Kabelaufbauten ausschließen, die im strengen Sinn des Wortes nicht unter konzentrisch fallen. Die erfindungsgemäße Methode läßt sich selbstverständlich auch auf anders konfigurierte Kabel, beispielsweise Flachbandkabel anwenden. In diesem Fall werden die zu schützenden Leiter dann von den Schirmleitern und den dazwischen befindlichen Isolierschichten in Form von übereinander befindlichen Schläuchen mit nicht-kreisförmigem Querschnitt umgeben.

Wenn das zu schützende Kabel in einem als Erdung dienenden Rohr oder Gehäuse untergebracht ist und die Systemerde des Kabels und die durch das Rohr bzw. Gehäuse gebildete allgemeine Erde galvanisch getrennt sind, braucht das Kabel selbst keinen Empfangsschirm aufzuweisen. Das der Erdung dienende Rohr oder Gehäuse kann dann die Funktion des Empfangschirms übernehmen. Das Kabel selbst braucht in diesem Fall nur zwei Schirmleiter aufzuweisen, nämlich den Sendeschirm und die Strahlungsabschirmung.

Um das Funktionieren der Kabelschutzvorrichtung sicherzustellen, ist es zu bevorzugen, Überwachungssender und Überwachungsempfänger in Tresorräumen zu installieren und mit Batterien zu puffern, damit sie immer in Betrieb sind.

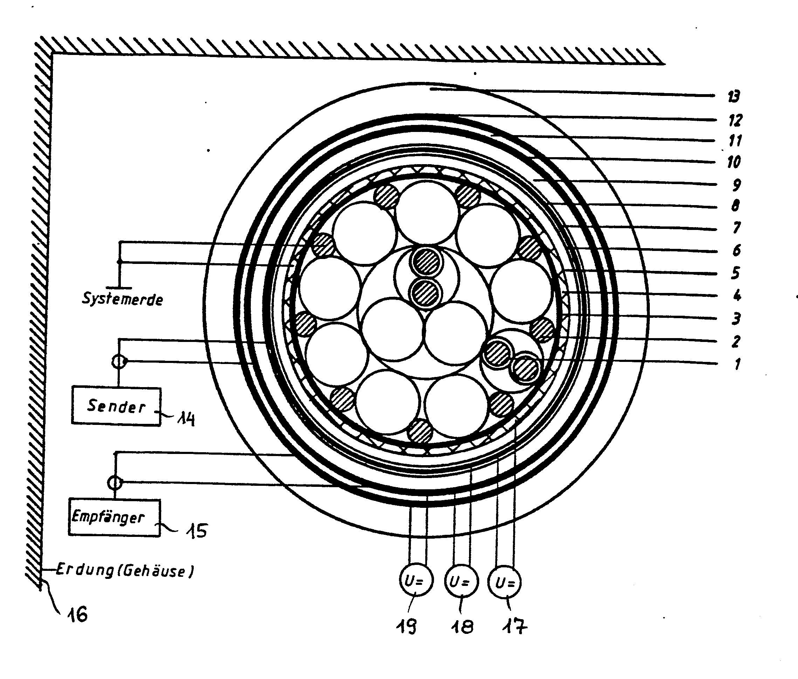

Die Erfindung und Weiterbildungen der Erfindung werden nun anhand einer bevorzugten Ausführungsform erläutert, die in der einzigen Figur dargestellt ist.

Die Figur zeigt den Querschnitt eines Kabels mit einer Vielzahl von Nutzleitern 1, die der Datenübertragung dienen. Bei der dargestellten Ausführungsform bilden je zwei Nutzleiter 1, die in einen gemeinsamen Isolierstoffkörper eingebettet sind, eine zweiadrige Leitung. Der Innenaufbau des Kabels wird durch eine Vielzahl solcher zweiadriger Leitungen gebildet. Zwischen den Isolierstoffkörpern der am Außenumfang des Kabelinnenaufbaus befindlichen zweiadrigen Leitungen befinden sich Beidrähte 2.

Den Kabelinnenaufbau umgibt ein Kabelaußenaufbau, der durch eine Anzahl unterschiedlicher, zur Kabelachse und zueinander konzentrische Lagen gebildet ist. Von innen nach außen betrachtet wird der Kabelaufbau durch folgende Lagen gebildet: Die den Kabelinnenaufbau unmittelbar umgebende Lage wird durch einen Folienschirm 3 gebildet. Darauf folgt ein Schirmgeflecht 4. Über diesem befindet sich ein erstes Dielektrikum 5. Darauf folgt eine erste Isolation 6, die mechanischen Schutz bietet. Diese Lage kann bei entsprechender Festigkeit des Dielektrikums 5 entfallen. Als nächstes folgt ein elektrisch leitender Sendeschirm 7. Über diesem befindet sich eine zweite Isolation 8, die mechanischen Schutz bietet. Auf die zweite Isolation 8 folgt ein zweites Dielektrikum 9. Über diesem ist eine als Strahlungsabschirmung 10 dienende elektrisch leitende Lage angeordnet. Auf diese folgt eine dritte Isolation 11. Darüber befindet sich ein elektrisch leitender Empfangsschirm 12. Den äußeren Abschluß bildet ein Außenisoliermantel 13.

An einer Stelle des Kabels, die vor unbefugtem Zugriff gesichert ist, sich beispielsweise in einem Tresorraum befindet, sind ein Sender 14 und ein Empfänger 15 angeordnet. Ein Ausgangsanschluß des Senders 14 ist mit dem Sendeschirm 7 des Kabels verbunden. Ein Eingangsanschluß des Empfängers 15 ist mit dem Empfangsschirm 12 des Kabels verbunden. Die Strahlungsabschirmung 10 des Kabels ist mit je einem Bezugspotentialanschluß des Senders 14 und des Empfängers 15 verbunden.

Zwischen das Schirmgeflecht 4 und den Sendeschirm 7 ist eine erste Gleichspannungsquelle 17 geschaltet. Eine zweite Gleichspannungsquelle 18 befindet sich zwischen dem Sendeschirm 7 und der Strahlungsabschirmung 10. Zwischen die Strahlungsabschirmung 10 und den Empfangsschirm 12 ist eine dritte Gleichspannungsquelle 19 geschaltet.

Die aus den Beidrähten 2, dem Folienschirm 3 und dem Schirmgeflecht 4 gebildete Abschirmung schützt die Nutzleiter 1 vor Störungen von außen und verhindert, daß Impulse von den Nutzleitern 1 nach außen dringen. Das erste Dielektrikum 5 und die erste Isolation 6 isolieren den Hochfrequenz führenden Sendeschirm 7 von der Abschirmung 2, 3, 4 und ermöglichen eine definierte Impedanz.

Der Schutz des Kabels wird mit einem hochfrequenten Signal bewirkt, das vom Sender 14 auf den Sendeschirm 7 gegeben wird. Vorzugsweise wird das hochfrequente Signal definiert moduliert, um es jederzeit von irgendwelchen Störsignalen unterscheiden zu können. Die Strahlungsabschirmung hat eine Doppelfunktion. Sie bildet nicht nur ein Bezugspotential für das Hochfrequenzsignal sondern sie bewirkt im unversehrten Zustand auch, daß keine vom Sendeschirm 7 ausgehenden Feldlinien den Empfangsschirm 12 erreichen. Der Empfangsschirm 12 stellt eine Antenne für den Empfänger 15 dar, wobei die Strahlungsabschirmung 10 wieder das Bezugspotential bildet.

Im normalen Betriebszustand, d.h. bei unversehrtem Kabel, kann der Empfangsschirm 12 das Hochfrequenzsignal nicht empfangen, da die Strahlungsabschirmung 10 elektrisch dicht ist und keine Feldlinien der Hochfrequenzenergie durchläßt.

Will nun jemand zu dem die Nutzleiter 1 enthaltenden Kabelinnenaufbau vordringen, muß er die den Kabelinnenaufbau umgegenden Schirme 12, 10 und 7 öffnen. In dem Moment, in welchem die Strahlungsabschirmung 10 geöffnet wird, treten vom Sendeschirm 7 ausgehende Feldlinien aus und gelangen zum Empfangsschirm 12, was mit Hilfe einer dem Empfänger 15 zugeordneten Auswerteeinrichtung festgestellt werden kann. Auf diese Weise wird die am Kabel vorgenommene Manipulation detektiert.

Sind Systemerde und allgemeine Erde der Anlage voneinander getrennt, besteht die Möglichkeit, den Empfangsschirm 12 mit dem Gehäuse 16 der Anlage zu verbinden. Dies führt zu einer wesentlichen Erhöhung der Empfindlichkeit.

Wird das das Kabel umgebende Gehäuse 16 als Empfangsantenne verwendet, kann der Empfangsschirm 12 des Kabels wegfallen. Wird das dem Kabelschutz dienende Hochfrequenzsignal nur in Datenübertragungspausen ausgestrahlt, kann die Abschirmung 2, 3, 4 eingespart werden.

Mit den Gleichspannungsquellen 17, 18, 19 werden Kurzschlüsse zwischen den Schirmen 7, 10 und 12 überwacht. Zu diesem Zweck sind an diese Schirme Kurzschlußdetektoren angeschlossen, die beispielsweise auf eine durch Kurzschluß verursachte Spannungsabsenkung oder Stromerhöhung ansprechen.

Die einzelnen Schirme des Kabels können als Drahtschirme in Flecht-oder Wickeltechnik mit oder ohne Beidrähte ausgebildet sein. Sie können auch als Folienschirm gewickelt oder geflochten, durch Metallschichten ein-oder beidseitig metallisch beschichteter Trägerfolien oder aus reinen Metallfolien gebildet sein.

Je nach speziellen Anforderungen kann das Kabel als Rundkabel, Flachkabel oder Koaxialkabel ausgebildet sein. Wichtig ist nur, daß alle zu - schützenden Nutzleiter innerhalb der Strahlungsabschirmung angeordnet sind und der Sendeschirm und der Empfangsschirm auf verschiedenen Seiten der Strahlungsabschirmung angeordnet sind. Dabei müssen der Sendeschirm nicht innerhalb und der Empfangsschirm nicht außerhalb der Strahlungsabschirmung angeordnet sein. Man kann auch den Sender an den äußeren und den Empfänger an den inneren Schirm anschließen.

## Ansprüche

1. Kabelschutzvorrichtung zur Überwachung eines Nutzleiter und Überwachungsleiter aufweisenden elektrischen Kabels auf Unversehrtheit, wobei die Überwachungsleiter an einen Überwachungssender und einen mit einer Auswerteeinrichtung verbundenen Überwachungsempfänger angeschlossen sind, dadurch **gekennzeichnet,** daß der Überwachungssender (14) und der Überwachungsempfänger (15) je für Hochfrequenzbetrieb ausgebildet sind, und daß die Überwachungsleiter mindestens drei Schirmleiter (7, 10, 12; 7, 10, 16) umfassen, die mindestens eine Teilanzahl der Nutzleiter (1) in mehreren konzentrischen Lagen umgeben und sowohl von den Nutzleitern (1) als auch voneinander elektrisch isoliert sind, und von denen ein erster an den Überwachungssender (14) angeschlossen ist und einen Sendeschirm (7) bildet, ein zweiter an den Überwachungsempfänger (15) angeschlosen ist und einen Empfangschirm (12; 16) bildet, und ein dritter, zwischen Sendeschirm (7) und Empfangsschirm (12) angeordneter, eine Strahlungsabschirmung (10) bildet, die in unversehrtem Zustand den Empfangsschirm (12; 16) vor der vom Sendeschirm (7) abgestrahlten Sendeenergie abschirmt, so daß der Überwachungsempfänger (15) nur im versehrten Zustand mit Hochfrequenzenergie beaufschlagt wird.

2. Kabelschutzvorrichtung nach Anspruch 1, dadurch **gekennzeichnet,** daß von den drei konzentrischen Schirmleitern (7, 10, 12; 16) der innerste (7) an den Überwachungssender (14) und der äußerste (12; 16) an den Überwachungsempfänger (15) angeschlossen ist.

3. Kabelschutzvorrichtung nach Anspruch 1 oder 2, dadurch **gekennzeichnet,** daß die Strahlungsabschirmung (10) den Bezugspotentialleiter sowohl für den Sendeschirm (7) als auch für den Empfangsschirm (12; 16) bildet.

4. Kabelschutzvorrichtung nach Anspruch 2 oder 3, dadurch **gekennzeichnet,** daß der Empfangsschirm durch einen das Kabel mindestens teilweise umgebenden Erdungsleiter (16) gebildet ist.

5. Kabelschutzvorrichtung nach Anspruch 4, dadurch **gekennzeichnet,** daß der Erdungsleiter (16) durch ein das Kabel aufnehmendes metallisches Gehäuse gebildet ist.

6. Kabelschutzvorrichtung nach einem oder mehreren der Ansprüche 1 bis 5, dadurch **gekennzeichnet,** daß zwischen Sendeschirm (7) und Strahlungsabschirmung (10) und zwischen Strahlungsabschirmung (10) und Empfangsschirm (12; 16) je eine Kurzschlußüberwachungseinrichtung angeschlossen ist.

7. Kabelschutzvorrichtung nach Anspruch 6, dadurch **gekennzeichnet,** daß die Kurzschlußüberwachungseinrichtungen jè eine Gleichspannungsquelle (17, 18, 19) und einen Kurzschlußstromdetektor aufweisen.

8. Kabelschutzvorrichtung nach einem oder mehreren der Ansprüche 1 bis 7, dadurch **gekennzeichnet,** daß beim Auftreten eines Ausgangssignals des Überwachungsempfängers (15) die Datenübertragung über das Kabel automatisch unterbrochen wird.

9. Kabelschutzvorrichtung nach einem oder mehreren der Ansprüche 1 bis 8, dadurch **gekennzeichnet,** daß der Überwachungssender (14) ein definiert moduliertes Hochfrequenzsignal aussendet.

10. Für die Kabelschutzvorrichtung nach einem oder mehreren der Ansprüche 1 bis 9 geeignetes elektrisches Kabel mit einem Nutzleiter einschließenden ersten Isoliermantel, dadurch **gekennzeichnet,** daß der erste Isoliermantel (3, 4) in konzentrischen Lagen von einem inneren Schirmleiter (7), einem mittleren Schirmleiter (10) und einem äußeren Schirmleiter (12) und von zwischen den einzelnen Schirmleitern befindlichen weiteren Isoliermänteln (8, 9, 11) umgeben ist.

11. Für die Kabelschutzvorrichtung nach einem oder mehreren der Ansprüche 4 bis 7 geeignetes elektrisches Kabel mit einem Nutzleiter einschließenden ersten Isoliermantel, dadurch **gekennzeichnet,** daß der erste Isoliermantel (5) in konzentrischen Lagen von einem inneren Schirmleiter (7) und einem äußeren Schirmleiter (10) und einem dazwischen befindlichen weiteren Isoliermantel (11) umgeben ist.

12. Kabel nach Anspruch 10 oder 11, dadurch **gekennzeichnet,** daß der äußere Schirmleiter (10; 12) von einem Außenisoliermantel (13) umgeben ist.

13. Kabel nach einem oder mehreren der Ansprüche 10 bis 12, dadurch **gekennzeichnet,** daß mindestens einer der Schirmleiter durch eine Metallfolie gebildet ist.

14. Kabel nach einem oder mehreren der Ansprüche 10 bis 12, dadurch **gekennzeichnet,** daß mindestens einer der Schirmleiter durch die Metallschicht einer metallbeschichteten Trägerfolie aus Isoliermaterial gebildet ist.

15. Kabel nach Anspruch 14, dadurch **gekennzeichnet,** daß die Trägerfolie beidseits metallisch beschichtet ist.

16. Kabel nach einem oder mehreren der Ansprüche 10 bis 15, dadurch **gekennzeichnet,** daß mindestens einer der Schirmleiter durch ein Drahtgeflecht gebildet ist.

17. Kabel nach einem oder mehreren der Ansprüche 10 bis 16, dadurch **gekennzeichnet,** daß mindestens einer der Schirmleiter durch eine Drahtwicklung gebildet ist.

Systemerde

Sender — 14

Empfänger — 15

Erdung (Gehäuse)

16

13
12
11
10
9
8
7
6
5
4
3
2
1

U= U= U=
19 18 17